(19) Europäisches Patentamt
European Patent Office
Office européen des brevets

(11) Numéro de publication : **0 560 681 A1**

(12) # DEMANDE DE BREVET EUROPEEN

(21) Numéro de dépôt : **93400622.2**

(51) Int. Cl.[5] : **G01R 33/24**

(22) Date de dépôt : **11.03.93**

(30) Priorité : **13.03.92 FR 9203011**

(43) Date de publication de la demande : **15.09.93 Bulletin 93/37**

(84) Etats contractants désignés : **DE GB IT**

(71) Demandeur : **COMMISSARIAT A L'ENERGIE ATOMIQUE**
**31-33, rue de la Fédération**
**F-75015 Paris (FR)**

(71) Demandeur : **CENTRE NATIONAL DE LA RECHERCHE SCIENTIFIQUE**
**15, quai Anatole France**
**F-75007 Paris (FR)**

(72) Inventeur : **Theurel, Laurence**
**20 rue Diderot**
**F-38000 Grenoble (FR)**
Inventeur : **Moussavi, Medhi**
**20 rue Joseph Rolland**
**F-38120 Saint Egreve (FR)**
Inventeur : **Marchon, Jean-Claude**
**Le Montalieu**
**F-38660 Saint Vincent de Mercuze (FR)**

(74) Mandataire : **Mongrédien, André**
**c/o BREVATOME 25, rue de Ponthieu**
**F-75008 Paris (FR)**

(54) **Matériau organique utilisable dans un magnétomètre et sonde pour magnétomètre à résonance paramagnétique électronique (RPE) utilisant ce matériau.**

(57) L'invention concerne un matériau organique (5) utilisable dans un magnétomètre à résonance paramagnétique électrique (RPE), ainsi qu'une sonde (3) utilisant ce matériau.

Le but de l'invention est de réaliser un matériau présentant simultanément une faible largeur de raie (RPE), une bonne tenue en température et qui ne réagisse pas en présence d'eau.

Ce but est atteint à l'aide d'un sel de cation radicalaire de formule :

$$(Ar)_2{}^{\cdot +}X^-$$

dans laquelle Ar représente un hydrocarbure aromatique non substitué ou substitué par au moins un élément choisi dans le groupe constitué des atomes d'halogène ou des radicaux alkyles et alcoxy, et $X^-$ est un anion choisi parmi $TeOF_5{}^-$ ou $SeOF_5{}^-$.

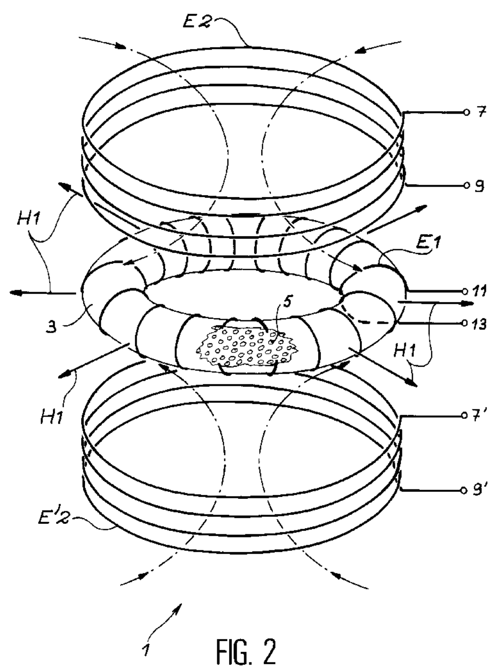


FIG. 2

EP 0 560 681 A1

La présente invention a pour objet un matériau organique utilisable dans un magnétomètre ainsi qu'une sonde de magnétomètre à résonance paramagnétique électronique (RPE) utilisant ce matériau.

Les magnétomètres à résonance paramagnétique électronique (RPE) permettent de mesurer des valeurs de champ magnétique extrêmement faibles et généralement inférieures ou égales à l'intensité du champ terrestre. Ces magnétomètres fonctionnent à l'aide d'une substance présentant un moment magnétique électronique.

Cette substance doit présenter une largeur de raie RPE faible pour permettre des mesures précises avec la sonde du magnétomètre. En effet, on sait que la sensibilité du magnétomètre est inversement proportionnelle au cube de la largeur de raie RPE du matériau.

On connaît déjà d'après l'art antérieur, des sels de cations radicalaires de formule $(Ar)_2{}^{\cdot+}X^-$, dans laquelle Ar représente un hydrocarbure aromatique et X un anion et qui présentent un moment magnétique électronique suffisant pour pouvoir être utilisé dans les sondes des magnétomètres.

Ces matériaux radicalaires sont préparés par la réaction électrochimique suivante :

$$Ar + TBAX \xrightarrow[\text{solvant}]{\text{courant}} (Ar)_2{}^{\cdot+} X^-$$

dans laquelle TBA représente le tétrabutylammonium, Ar et X ayant la même signification que précédemment.

On connaît déjà d'après le document FR-2 631 958, un sel de cation radicalaire de formule $(Ar)_2{}^{\cdot+}X^-$, dans lequel Ar représente le tétrahydro-1,2,7,8-cyclopenta [cd ; lm] pérylène et X un hexafluoroarséniate ($AsF_6$) ou de préférence, un hexafluorophosphate ($PF_6^-$). Ces sels de cation sont solvatés, c'est-à-dire qu'ils contiennent x molécules de solvant $CH_2Cl_2$ par molécule de $(Ar_2)PF_6$. Ces sels présentent un certain nombre d'inconvénients. En effet, la sonde de magnétomètre RPE peut être utilisée jusqu'à des températures supérieures à la température ambiante, c'est-à-dire aux environs de 450°C. En conséquence, les matériaux radicalaires utilisés à l'intérieur de cette sonde doivent avoir une bonne tenue en température ainsi que des performances ne variant pas en fonction de celle-ci. Or, dans le cas des sels solvatés, la synthèse de ceux-ci est non reproductible du fait du nombre variable de molécules de solvant $CH_2Cl_2$ incluses. Les caractéristiques des matériaux radicalaires obtenus sont dépendantes du nombre de molécules de solvant, donc des conditions d'électrocristallisation réunies lors de leur fabrication et notamment de la température. Afin d'obtenir des performances stables, il est donc nécessaire de procéder à un recuit du matériau aux environs de 60°C, pendant 2 heures. Cette technique de recuit est justement décrite dans le document qui vient d'être cité et a pour but d'éliminer le solvant qui se trouve dans le réseau cristallin. En outre, ce recuit permet de diminuer la largeur de raie RPE. Sans ce recuit, les caractéristiques de la sonde seraient susceptibles de varier avec la température d'utilisation de celle-ci.

On connaît également d'après le document FR 2 648 457, un sel de cation radicalaire de formule $(FA)_2{}^{\cdot+}PF_6^-$, dans lequel FA représente le fluoranthène. Ce cation radicalaire n'est pas solvaté et présente une raie RPE très fine. Ce cation ne nécessite pas de recuit. Par contre, il est très instable même à température ambiante. En effet, en présence d'eau, même si celle-ci n'existe qu'à l'état de traces, il se décompose suivant le schéma réactionnel suivant :

$$2(FA)_2PF_6 + 9H_2O \rightarrow 2H_3PO_4 + 12HF + 1/20_2 + 4(FA).$$

Dans ce schéma réactionnel, FA représente le fluoranthène.

Cette réaction a lieu même si l'eau n'est présente qu'à l'état de traces, en particulier sous forme d'inclusions dans les cristaux produits lors de l'électrocristallisation de l'hexafluorophosphate de fluoranthène par les procédés classiques.

Les effets néfastes de cette réaction de décomposition sont les suivants :

- la production d'acides phosphorique et fluorhydrique qui accélère la dégradation du radical par effet catalytique,
- l'élargissement de la raie RPE du sel en raison du dégagement d'oxygène, car il se produit un couplage entre le spin électronique du radical et l'oxygène paramagnétique.

La manifestation de ces effets se traduit par la formation de microcristaux de fluoranthène, généralement blancs qui en se déposant à la surface des cristaux du sel de cation radicalaire (noirs ou violets) leur donne une couleur grise. Par ailleurs, le dégagement d'acide fluorhydrique (fumée blanche) rend opaques les parois de la sonde en magnétomètrie RPE car celle-ci est généralement réalisée en verre qui est attaqué par l'acide fluorhydrique.

Cette dégradation est due à la grande réactivité de l'anion $PF_6^-$ vis-à-vis de l'eau. Le cation radicalaire $(Fa)_2{}^{\cdot+}PF_6^-$ doit donc être conservé à froid et en présence d'un matériau capable d'absorber l'eau tel qu'un tamis moléculaire zéolithique, comme cela est décrit dans le document FR 2 648 457 précité.

En conséquence, les deux types de cations radicalaires qui viennent d'être cités ne sont pas satisfaisants puisqu'ils posent des problèmes de solvatation ou d'instabilité. Ces inconvénients les rendent difficiles à utiliser dans une sonde de magnétomètre RPE et oblige le fabricant à procéder à des étapes supplémentaires lors de la préparation de cette sonde, à savoir le recuit du cation ou l'addition d'un matériau capable d'absorber l'eau.

La présente invention a pour but de remédier à ces inconvénients.

A cet effet, l'invention concerne un matériau organique utilisable dans un magnétomètre à résonance paramagnétique électronique.

Selon les caractéristiques de l'invention, ce matériau est constitué d'un sel de cation radicalaire de formule :

$$(Ar)_2^{\cdot +} X^-$$

dans laquelle Ar représente un hydrocarbure aromatique non substitué ou substitué par au moins un élément choisi dans le groupe constitué des atomes d'halogène ou des radicaux alkyles et alcoxy, et $X^-$ est un anion choisi parmi $TeOF_5^-$ ou $SeOF_5^-$.

De façon avantageuse, Ar représente un hydrocarbure aromatique choisi parmi le naphtalène, le fluoranthène, le pérylène, le pyrène ou le triphénylène.

Ce matériau radicalaire est stable, non solvaté et présente une bonne tenue à la température. Il présente une largeur de raie RPE minimum de 100 mG et une largeur de raie au maximum de la pente du signal de 205 mG à 280 mHz. En conséquence, il peut être utilisé dans une sonde de magnétomètre RPE. En effet, dans l'art antérieur, l'instabilité du radical $(FA)_2PF_6$ était due à la forte réactivité du $PF_6^-$ vis-à-vis de l'eau. Les deux anions ici sélectionnés sont moins réactifs que le $PF_6$ mais ont toutefois des propriétés très proches de celuici en ce qui concerne la taille, la géométrie octaédrique et l'électronégativité, afin de conserver la même stoechiométrie et géométrie que dans le cation $(Ar)_2^+PF_6^-$ . La combinaison utilisant comme anion le pentaorthofluorotellurate ($TeOF_5^-$), appelé plus simplement TEFLATE (marque déposée) est préférée. Cet anion est décrit notamment dans l'article de S.H. STRAUSS, K.D. ABNEY, Inorg. Chem. 1984, 23, 515-516.

Ces propriétés sont très proches de celles de $PF_6^-$, comme on peut le constater à la lecture du tableau 1 suivant.

Tableau 1

| | P | Te |
|---|---|---|
| Rayon ionique (Å) | 0,35 | 0,56 |
| Electronégativité | 2,1 | 2,1 |
| Distance | P-F 1,9 | Te-F 1.85 |
| entre atomes (Å) | | Te-O 1.79 |

Enfin, l'invention concerne également une sonde pour magnétomètre à résonance paramagnétique électronique (RPE) comprenant un tube contenant une substance présentant un moment magnétique électronique, choisie parmi les matériaux organiques qui viennent d'être décrits.

La présente invention sera mieux comprise à la lecture de la description suivante d'un mode de réalisation de l'invention, donnée à titre d'exemple purement illustratif et non limitatif, cette description étant faite en faisant référence aux dessins joints, dans lesquels :

- la figure 1 est un graphique illustrant le spectre RPE d'un des matériaux organiques selon l'invention, respectivement immédiatement après préparation et après recuit,
- la figure 2 représente schématiquement la sonde torique d'un magnétomètre RPE contenant le matériau organique (sel de cation radicalaire) selon l'invention, et
- la figure 3 est semblable à la figure 2 mais avec une sonde cylindrique.

Parmi les sels de cation radicalaires selon l'invention, le cation $(Ar)_2TeOF_5$ et sa préparation vont maintenant être décrits.

Le cation radicalaire $(Ar)_2TeOF_5$ est préparé selon la réaction électrochimique suivante :

$$\text{(I) Ar + TBATeOF}_5 \xrightarrow[\text{solvant}]{\text{courant}} (Ar)_2^{\cdot +} TeOF_5^-$$

Ar représentant un hydrocarbure aromatique non substitué ou substitué par au moins un élément choisi dans le groupe constitué des atomes d'halogène ou des radicaux alkyles et alcoxy et TBA représentant le tétrabutylammonium.

Le $TBATeOF_5$ est préparé en deux étapes suivant le schéma réactionnel suivant :

(1) $Te(OH)_6 + 5HSO_3F \rightarrow Te(OH)F_5 + 5H_2SO_4$

(2) $Te(OH)F_5 + TBACl \rightarrow TeOF_5TBA + HCl$

La première réaction de synthèse (1) est décrite dans l'article de S. FLADKY, Inorg. Synth., 1986, 24, 33-36. La seconde réaction de synthèse (2) est décrite dans l'article de S. H. STRAUSS, K.D. ABNEY et O.P.

ANDERSON, Inorg. Chem., 1986, 25, 2806-2812.

Le sel de $TBATeOF_5$ obtenu est purifié par recristallisation. On utilise comme solvant dans la réaction (I) précitée, le dichlorométhane, purifié avant utilisation par la procédure décrite dans la littérature (Purification of Laboratory Chemicals, D.D. PERRIN, W.L.F. ARMAREGO, Pergamon Press, 1988, 145).

Un exemple de réalisation plus précis de synthèse de pentaorthofluorotellurate de pérylène va maintenant être décrit.

Exemple

L'électrocristallisation est réalisée à l'abri de la lumière à une température de -80°C, dans une cellule à double compartiment semblable à celle décrite dans le document FR 2 648 457. La densité de courant appliquée est de l'ordre de 4 $\mu A/cm^2$. Le courant est appliqué aux bornes d'électrodes en platine plongeant dans une solution de 40 mg de pérylène et de 200 mg de tétrabutylammonium pentaorthofluorotellurate, présente dans chaque compartiment. Après deux jours, on recupère par filtration les cristaux de $(Pe)_2TeOF_5$ (Pe représentant le perylène) formés et après lavage avec du dichlorométhane (3x50 ml), on obtient 50 mg de cristaux représentant sous forme d'aiguilles noires.

En outre, on a réalisé deux spectres RPE correspondant au produit radicalaire récemment synthétisé et au même produit recuit. Ces résultats sont illustrés en figure 1 où le sel de cation radicalaire est le $(Pe)_2TeOF_5$. La courbe en traits pleins illustre le spectre RPE obtenu avec un sel récemment synthétisé et la courbe en traits mixtes, le spectre RPE obtenu avec un sel recuit à 80°C pendant 1 heure. L'axe des abscisses représente le champ magnétique exprimé en Gauss et l'axe des ordonnées, l'amplitude du signal RPE exprimé en $\mu$Gauss.

A une fréquence de 280 MHz, le champ magnétique RPE est de 100 Gauss. Pour observer le signal RPE, on effectue un balayage du champ magnétique autour de cette valeur de 100 Gauss (ici de 99,5 à 100,5 G).

Ce sel présente une largeur de raie L de 205 mG à 280 MHz pour des conditions de pente maximum du signal. Son amplitude A de crête à crête est de 638 $\mu$G.

Ces deux spectres RPE pratiquement identiques illustrent la parfaite stabilité des caractéristiques RPE de ce nouveau produit.

Plus précisément, la valeur de l'amplitude du signal RPE en $\mu$G a été ramenée en G de façon à pouvoir calculer la pente du signal entre les deux crêtes et à obtenir une valeur sans unité. Ainsi, pour la courbe en trait plein, la pente a une valeur de $21879.10^{-6}$ et pour la courbe en traits mixtes, la pente a une valeur de $20197.10^{-6}$. Cette très faible variation de pente illustre la stabilité du produit et donc ces performances pour son utilisation en magnétométrie.

A titre de comparaison, l'hexafluorophosphate de tétrahydro-1,2,7,8-cyclopentapérylène décrit dans le document FR 2 631 958 se dégrade justement à partir de 80°C.

Les sels de cations radicalaires obtenus selon l'invention sont alors introduits dans la sonde d'un magnétomètre RPE conforme à l'invention. Un premier mode de réalisation de celle-ci est représenté de façon schématique en figure 2.

Le magnétomètre comprend une sonde 1 et des moyens électroniques qui ne sont pas représentés sur la figure 2. La sonde 1 est formée d'un tube 3 torique rempli d'un sel de cation radicalaire 5 choisi parmi ceux de l'invention. Ce tube, qu'il n'est pas nécessaire de rendre étanche aux gaz, peut être réalisé en verre ou en un autre matériau, par exemple en matière plastique, ne donnant pas de signal RPE parasite. Ce tube 3 est entouré d'un premier enroulement $E_1$ bobiné autour de la paroi de verre et apte à produire une tension due à une variation de flux magnétique détectée. Deux enroulements $E_2$ et $E'_2$ constitués par des bobines de Helmholtz sont associés au tube 3 de part et d'autre du plan médian de ce tube. Les bobines sont coaxiales au tube 3 mais alimentées de telle sorte que les champs magnétiques qu'elles créent soient en opposition. Il en résulte des lignes de champ formant dans le plan médian du tube 3 un champ $H_1$ de distribution radiale. Les connexions 7, 9 et 7', 9' permettent d'amener le courant dans les bobines $E_2$' et $E'_2$, tandis que les connexions 11, 13 permettent de prélever le signal sortant de l'enroulement $E_1$. Les moyens électroniques permettent d'une part de mesurer la fréquence du signal prélevé aux connexions 11 et 13 et d'autre part de délivrer le champ magnétique $H_1$.

La sonde illustrée sur cette figure 2 ne représente toutefois qu'un exemple de réalisation. Le sel de cation radicalaire selon l'invention peut également être utilisé dans la sonde d'un magnétomètre présentant une structure différente, cette sonde étant illustrée en figure 3.

Cette sonde est constituée par un tube cylindrique 15 rempli d'un sel de cation radicalaire selon l'invention. Le tube 15 est entouré d'un premier enroulement $E_3$ bobiné autour du tube et apte à produire une tension due à une variation de flux magnétique détectée. Deux enroulements $E_4$ et $E'_4$ constitués par des bobines de Helmholtz sont associés au tube 15. Ces bobines permettent de créer un champ magnétique tournant.

## Revendications

1. Matériau organique utilisable dans un magnétomètre à résonance paramagnétique électronique, caractérisé en ce qu'il est constitué d'un sel de cation radicalaire de formule :

$$(Ar)_2^{\cdot +}X^-$$

dans laquelle Ar représente un hydrocarbure aromatique non substitué ou substitué par au moins un élément choisi dans le groupe constitué des atomes d'halogène ou des radicaux alkyles et alcoxy, et $X^-$ est un anion choisi parmi $TeOF_5^-$ ou $SeOF_5^-$.

2. Matériau organique selon la revendication 1, caractérisé en ce que Ar représente un hydrocarbure aromatique choisi parmi le naphtalène, le fluoranthène, le pérylène, le pyrène ou le triphénylène.

3. Matériau organique selon la revendication 1, caractérisé en ce que Ar représente le perylène et $X^-$ le $TeOF_5^-$.

4. Sonde pour magnétomètre à résonance paramagnétique électronique (RPE) comprenant un tube (3, 15) contenant une substance (5) présentant un moment magnétique électronique, caractérisé en ce que cette substance (5) est le matériau organique selon l'une des revendications 1 à 3.

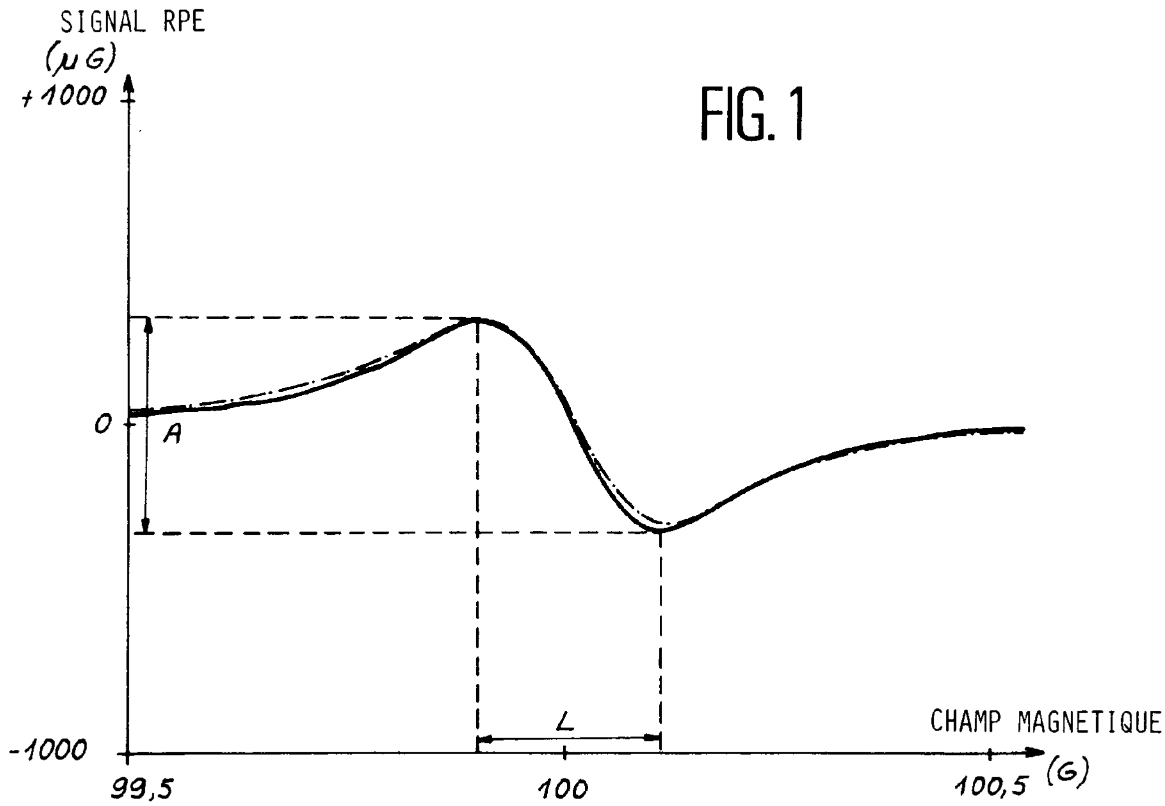
SIGNAL RPE
(µG)
+1000
0
-1000
A
L
CHAMP MAGNETIQUE
(G)
99,5
100
100,5

FIG. 1

FIG. 3

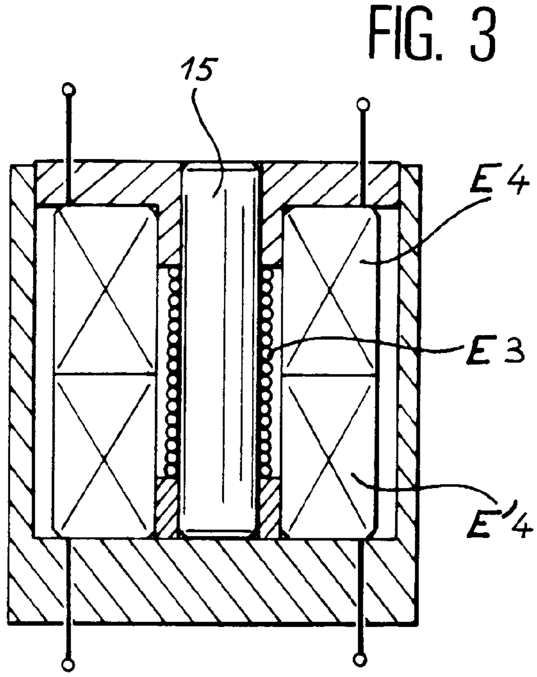
15
E4
E3
E'4

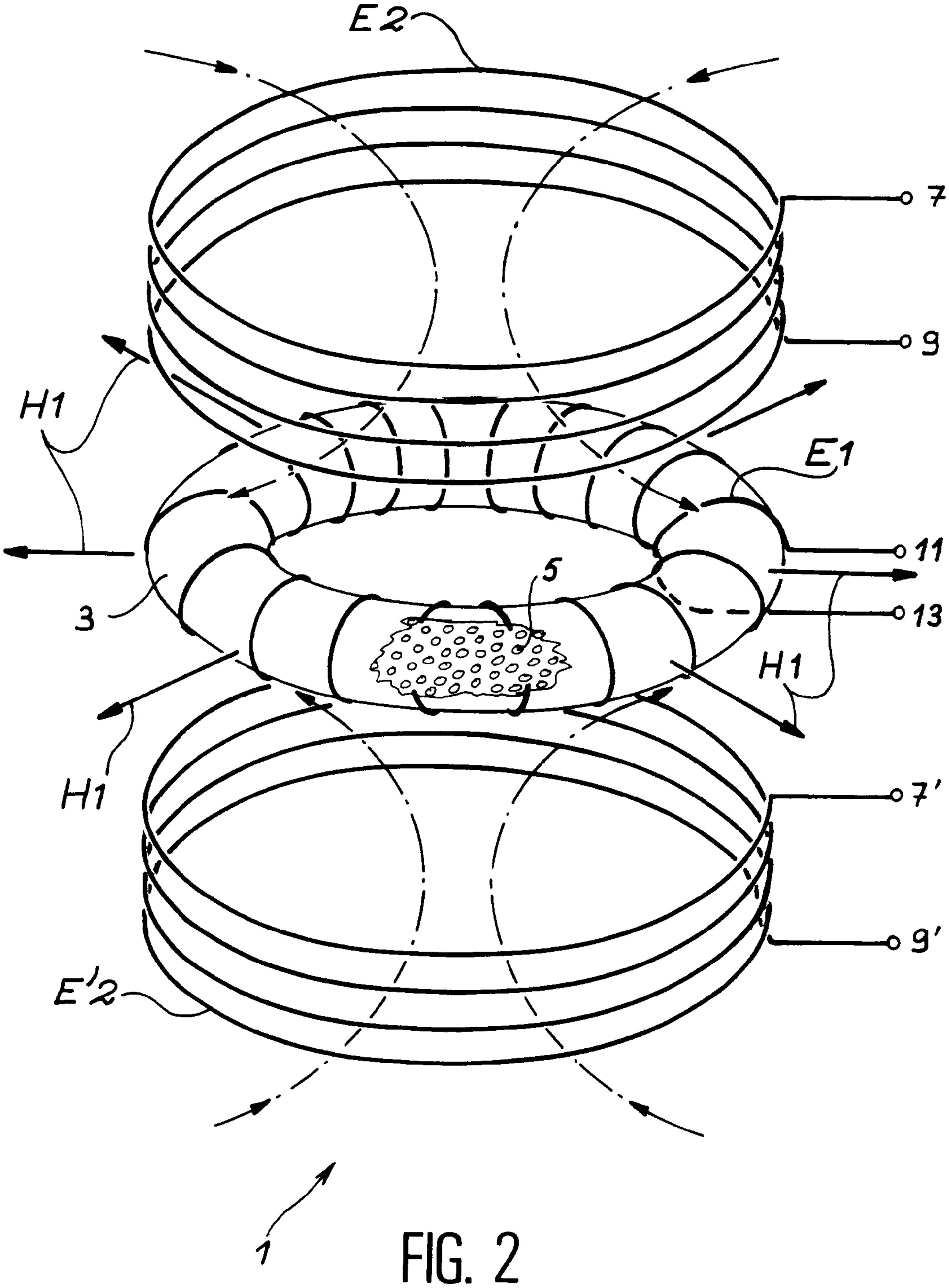


FIG. 2

Office européen des brevets

# RAPPORT DE RECHERCHE EUROPEENNE

Numero de la demande
EP 93 40 0622

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A,D | FR-A-2 648 457 (COMMISSARIAT A L'ENERGIE ATOMIQUE)<br>* page 1, ligne 5 - page 5, ligne 19 *<br>--- | 1,4 | G01R33/24 |
| A,D | FR-A-2 631 958 (THOMSON-CSF)<br>* page 1, ligne 12 - page 3, ligne 28 *<br>--- | 1,4 | |
| A | GB-A-2 225 015 (COMMISSARIAT A L'ENERGIE ATOMIQUE)<br>* abrégé *<br>* page 2, ligne 27 - page 10, ligne 3 *<br>--- | 1,4 | |
| A | EP-A-0 451 055 (COMMISSARIAT A L'ENERGIE)<br>* abrégé *<br>* page 2, ligne 1 - page 3, ligne 52 *<br>--- | 1,4 | |
| A | APPLIED PHYSICS A. SOLIDS AND SURFACES<br>vol. 30, no. 4, 1 Avril 1983, HEIDELBERG DE<br>pages 227 - 231<br>E. DORMANN ET AL. 'GAUSSMETER APPLICATION OF AN ORGANIC CONDUCTOR'<br>* le document en entier *<br>--- | 1,4 | DOMAINES TECHNIQUES RECHERCHES (Int. Cl.5 ) |
| A | JOURNAL OF PHYSICS E. SCIENTIFIC INSTRUMENTS<br>vol. 22, no. 5, 1 Mai 1989, BRISTOL GB<br>pages 321 - 324<br>H. GEBHARDT ET AL. 'ESR GAUSSMETER FOR LOW-FIELD APPLICATIONS'<br>* le document en entier *<br>--- | 1,4 | G01R<br>C07B<br>C07C<br>C25B |
| A | REVIEW OF SCIENTIFIC INSTRUMENTS.<br>vol. 62, no. 3, 1 Mars 1991, NEW YORK US<br>pages 685 - 694<br>D. DURET ET AL. 'A NEW ULTRA LOW-FIELD ESR SPECTROMETER'<br>* le document en entier *<br>----- | 1,4 | |

Le présent rapport a été établi pour toutes les revendications

| Lieu de la recherche | Date d'achèvement de la recherche | Examinateur |
|---|---|---|
| LA HAYE | 07 JUIN 1993 | HORAK G.I. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)